Europäisches Patentamt

European Patent Office

Office européen des brevets

(19)

(11) Numéro de publication: **0 272 184**
**A1**

## (12) DEMANDE DE BREVET EUROPEEN

(21) Numéro de dépôt: **87402817.8**

(22) Date de dépôt: **11.12.87**

(51) Int. Cl.⁴: **H01L 29/90**

(30) Priorité: **16.12.86 FR 8617566**

(43) Date de publication de la demande:
**22.06.88 Bulletin 88/25**

(84) Etats contractants désignés:
**CH DE GB IT LI NL SE**

(71) Demandeur: SGS-THOMSON
MICROELECTRONICS S.A.
**101, bld Murat**
**F-75016 Paris(FR)**

(72) Inventeur: **Jeudi, Patrice**
**THOMSON-CSF SCPI 19, avenue de Messine**
**F-75008 Paris(FR)**
Inventeur: **Anceau, Christine**
**THOMSON-CSF SCPI 19, avenue de Messine**
**F-75008 Paris(FR)**

(74) Mandataire: **Taboureau, James et al**
**THOMSON-CSF SCPI 19, avenue de Messine**
**F-75008 Paris(FR)**

(54) **Dispositif de protection contre les surtensions à faible capacité.**

(57) L'invention concerne un dispositif de protection contre les surtensions, de type diode à avalanche, pour montage en diode dite de clamping ou à écrêtage.

Un tel dispositif, fonctionnant sous polarisation inverse, présente une capacité qui peut perturber le circuit à protéger. Selon l'invention, la capacité de la diode de protection (7 - 10) est diminuée en montant en série une seconde diode (7 - 11), polarisée en direct mais non conductrice. Les deux diodes sont réalisées au moyen de deux régions (10 - 11), de même type de conductivité, diffusées ou implantées dans un substrat (7) de type de conductivité opposée. Les deux diodes sont en vis à vis, sur deux faces opposées du substrat (7).

Application à la protection des circuits électroniques contre les surtensions transitoires.

FIG_5

## DISPOSITIF DE PROTECTION CONTRE LES SURTENSIONS A FAIBLE CAPACITE

La présente invention concerne un dispositif électronique de protection contre les surtensions, de type composant monodirectionnel, réalisé en une seule pastille de matériau semiconducteur, plane, et à faible capacité. Ce dispositif de protection présente deux jonctions en série, sur les deux faces principales de la pastille de substrat semiconducteur.

Les dispositifs de protection contre les surtensions sont des composants électroniques de type diode, dont les caractéristiques sont proches des diodes zéners : ce sont des diodes à avalanche spécialement conçues pour écrêter les surtensions et dissiper en régime transitoire. Ils sont montés en dérivation sur les bornes de sortie d'une alimentation, ou en parallèle avec le circuit ou le composant à protéger, mais de telle façon qu'ils absorbent les surtensions, qu'elles viennent de l'alimentation ou de la charge. Mais la protection contre les surtensions accidentelles, telles que la conséquence d'un coup de foudre, une surtension de manoeuvre sur un réseau, une conséquence d'un court-circuit ou d'une rupture de câble, ne peut généralement pas se faire en un endroit unique, par exemple un gros dispositif de protection branché directement à l'entrée du réseau. En effet les surtensions parasites arrivent sur le circuit électronique par de multiples voies : capacités parasites, couplage inductif... et l'expérience montre que pour avoir une bonne protection il faut décentraliser cette protection, c'est-à-dire monter le dispositif de protection à l'endroit exact qui doit être protégé.

Il s'ensuit que la multiplication des diodes de protection en différents points d'un circuit électronique entraîne la multiplication de capacités parasites, car chaque diode de protection, comportant une jonction polarisée en inverse, équivaut à une faible capacité. Ces capacités peuvent perturber le fonctionnement du circuit protégé.

Le problème posé est donc d'abaisser la capacité, sous polarisation inverse, d'une diode de protection de type diode zéner ou à avalanche. La solution proposée est de monter une autre capacité en série avec celle de la diode de protection, cette seconde capacité étant constituée par une seconde diode polarisée en direct. De façon intégrée, la diode de protection étant réalisée par une jonction pn (ou np) à proximité d'une première face principale d'une pastille de matériau semiconducteur, la seconde diode est réalisée par une jonction np (ou pn) à proximité de la seconde face principale de la même pastille de matériau semiconducteur. Les deux diodes sont préférentiellement en vis-à-vis par rapport au substrat, mais n'ont pas obligatoirement les mêmes dimensions, ce qui permet de jouer sur les capacités de jonction.

De façon plus précise l'invention concerne un dispositif de protection contre les surtensions, de type diode à avalanche, réalisé de façon plane dans un substrat semiconducteur, et comportant sur une première face principale une première diode formée par une jonction entre le substrat d'un premier type de conductivité, ce dispositif étant caractérisé en ce que, en vue de diminuer sa capacité sous polarisation en inverse, une seconde capacité est montée en série avec la première diode et est intégrée dans le substrat du dispositif, sur la seconde face principale, en vis à vis de la première diode.

L'invention sera mieux comprise par la description plus détaillée qui suit d'une exemple de réalisation, et du procédé de fabrication d'un tel dispositif de protection contre les surtensions, cette description s'appuyant sur les figures jointes en annexe qui représentent :

-figure 1 : caractéristique intensité -tension d'une diode de protection, selon l'art connu,

-la figure 2 : schéma de montage d'une diode de protection, selon l'art connu,

-figures 3, 4 et 5 : schémas de réalisation du composant de protection selon l'invention, dont la structure est montrée en figure 5.

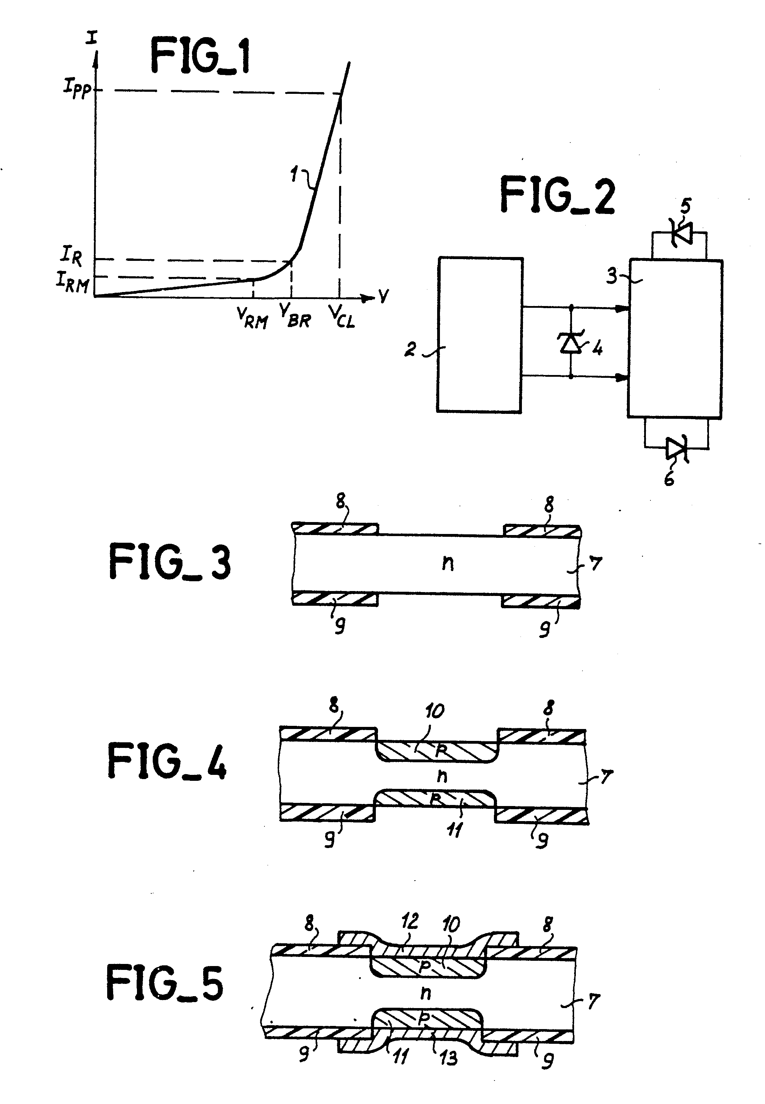

Le rappel préliminaire au moyen des figures 1 et 2, d'éléments qui sont connus, permettra de mieux comprendre le problème posé par les diodes de protection, et la solution envisagée au titre de la présente invention.

Les dispositifs de protection sont des composants qui peuvent supporter des surcharges définies sans être détruits. Ces surcharges simulent un certain nombre d'accidents qui peuvent endommager ou détruire les circuits électroniques. La protection de ces circuits par des composants à écrétage, qui sont également appelés diodes de clamping, se fait de façon parallèle afin d'éviter que le circuit à protéger voit les surtensions, tout en permettant de continuer à l'alimenter. Le mode de destruction des dispositifs de protection est le court-circuit.

La figure 1 représente la caractéristique de l'intensité en fonction de la tension dans une diode de protection classique. Une diode de protection a une caractéristique intensité en fonction de la tension telle que la courbe 1, qui est caractérisée par une tension de claquage $V_{BE}$ (BR = Breakdown) à laquelle correspond un courant inverse continu $I_R$, et par une tension d'écrétage $V_{CL}$ (CL = clamping) à laquelle correspond un courant inverse non répétitif de surcharge $I_{PP}$ (PP = PEAKPULSE). Pendant la majorité du temps de fonctionnement, une diode de protection fonctionne à l'état de veille, qui est au maximum la tension de veille maximale recommandée $V_{RM}$, à laquelle correspond un courant inverse $I_{RM}$. Pendant tout le temps où cette diode de protection est à l'état de veille, elle doit perturber le moins possible le circuit sur lequel elle est connectée, et par conséquent avoir une faible capacité.

La figure 2 donne le schéma de montage, très symbolisé, d'une diode de protection entre une alimentation telle que le bloc diagramme 2 et une charge ou circuit électronique tel que le bloc diagramme 3. Dans un premier cas possible une diode de protection 4 est montée en dérivation entre les deux bornes de sortie de l'alimentation 2, et elle protège le circuit 3 de surtensions qui peuvent provenir soit d'éléments perturbateurs sur le secteur, soit du fonctionnement même de l'alimentation stabilisée, par exemple de thyristors ou de triacs qui se déclenchent ou se bloquent. Mais une pluralité de diodes telles que 5 et 6 peuvent être également montées en parallèle avec des parties plus précises du circuit 3 à protéger : par exemple aux bornes d'un circuit logique, ou d'un relais, ou d'un potentiomètre dont la tension a une importance pour commander un sous-ensemble du circuit. Il peut donc y avoir dans un montage électronique une pluralité de diodes de protection, et comme ces diodes de protection comportent toutes des jonctions, elles présentent autant de capacités parasites qu'il y a de diodes de protection. Or pour chaque diode de protection la capacité est inversement proportionnelle à la largeur de la charge d'espace, sous la jonction : on pourrait pour diminuer la capacité diminuer la surface de la jonction, mais cela n'est pas une bonne solution parce qu'on a besoin d'une certaine surface de jonction dans le matériau semiconducteur pour dissiper une certaine intensité lors de la surtension, quelque soit son origine, par l'alimentation ou par le fonctionnement du circuit 3.

La solution proposée par l'invention consiste à monter en série avec la première capacité, constituée par la jonction de la diode de protection, une seconde capacité, de telle sorte que l'inverse de la capacité totale est égale, selon les lois bien connues, à la somme des inverses des deux capacités montées en série. Plutôt que de monter une capacité discrète en série avec une diode de protection discrète, selon l'art connu, la solution proposée est d'intégrer une seconde capacité, constituée par une diode montée en direct, dans le même substrat que celui qui comporte la diode de protection. La seconde diode, qui fonctionne en direct, est calculée pour ajouter en série une capacité de valeur non négligeable à la capacité de la diode de protection. A titre d'exemple pour une diode de protection polarisée en inverse, à proximité de sa tension de veille VRM, sa capacité est de l'ordre de 1 nF, et pour une diode polarisée en direct, sa capacité est de l'ordre de 2nF, l'ensemble des 2 diodes, montées en série à une capacité de 2/3 nF : on a donc nettement divisé la capacité de la diode de protection en lui ajoutant une seconde diode polarisée en direct.

Les figures 3 à 5 représentent différentes étapes de réalisation d'une diode de protection, dont la structure définitive est représentée en figure 5.

La première étape de réalisation consiste à partir d'une rondelle de matériau semiconducteur 7, qui est dopé d'un premier type de conductivité, par exemple de type n pour simplifier les explications. Cette rondelle constitue le substrat de la diode de protection, et deux masques d'un matériau tel que la silice ou le nitrure de silicium 8 et 9 sont déposés sur les deux faces principales de la rondelle 7. Par des opérations connues de gravure, des ouvertures sont réalisées dans les masques 8 et 9, ces ouvertures étant, au moins pour leur surface principale, en vis-à-vis. Dans une deuxième étape, représentée en figure 4, deux régions 10 et 11 sont réalisées, à travers les ouvertures dans les masques 8 et 9, dans le substrate 7. Ces deux régions 10 et 11 sont d'un type de conductivité opposé au type de conductivité de substrat, c'est-à-dire que dans l'exemple présenté ces deux régions sont de type p. La réalisation des régions 10 et 11 peut être faite par l'un quelconque des moyens connus telle que la diffusion en phase solide ou l'implantation ionique. Ces régions 10 et 11 constituent avec le substrat 7 deux jonctions pn et np, dont les caractéristiques précises sont à déterminer d'après la tension de claquage de la diode de protection, pour celle des deux jonctions qui est polarisée en inverse, et d'après la capacité désirée pour celle qui est polarisée en direct , et qui constitue donc la seconde diode.

Enfin, en figure 5, deux métallisations 12 et 13 sont déposées sur les régions 10 et 11, et ces métallisations permettent la prise de contact sur la diode de protection.

Si l'on admet que la région 10 et le substrat 7 constituent la première diode qui est la diode de protection, et que la région 11 et le substrat 7 constituent la deuxième diode qui est la diode apportant une capacité en série, la deuxième diode peut être plus petite que la première diode, ou au contraire plus grande, pour avoir moins ou au contraire plus de capacité montée en série. De même elle peut être moins dopée pour augmenter la charge d'espace et diminuer la capacité, ou au contraire être davantage dopée pour diminer les charges d'espace et augmenter la capacité. Les dimensions de la seconde diode peuvent être facilement réglées d'après les dimensions du masque 9, mais si la deuxième région 11 est plus ou moins dopée que la première région 10 cela suppose que le dopage se fait soit par deux opérations de diffusion différentes, soit par des conditions d'implantation différentes pour la première région 10 et pour la deuxième région 11.

Le dispositif de protection selon l'invention a été décrit comme étant un composant discret, mais il peut être intégré dans des dispositifs plus complexes, comportant outre le dispositif à deux jonctions décrits, d'autres composants tels que des thyristors, des triacs ou un réseau de transistors.

Il est utilisé de façon générale dans la protection contre les surtensions de circuits électroniques, de thyristors, de triacs ou de relais.

**Revendications**

1. Dispositif de protection contre les surtensions, de type diode à avalanche, réalisé de façon plane dans un substrat semiconducteur (7), et comportant sur une première face principale une première diode formée par une jonction entre le substrat (7) d'un premier type de conductivité, et une première région (10) d'un second type de conductivité, ce dispositif étant caractérisé en ce que, en vue de diminuer sa capacité sous polarisation en inverse, une seconde capacité est montée en série avec la première diode (7 - 10) et est intégrée dans le substrat (7) du dispositif, sur la seconde face principale, en vis à vis de la première diode.

2. Dispositif de protection selon la revendication 1, caractérisé en ce que la seconde capacité est constituée par une seconde diode, formée par la jonction entre le substrat (7) et une seconde région (11) de type de conductivité opposé à celui du substrat (7), cette seconde diode (7 - 11) étant donc polarisée en direct lorsque la première diode (7 - 10) est polarisée en inverse.

3. Dispositif de protection selon la revendication 2, caractérisé en ce que, en vue d'obtenir une valeur prédéterminée de la seconde capacité (7 - 11), les dimensions géométriques de la seconde région (11) sont indépendantes de celles de la première région (10).

4. Dispositif de protection selon la revendication 2, caractérisé en ce que, en vue d'obtenir une valeur prédéterminée de la seconde capacité (7 - 11), le niveau de dopage de la seconde région (11) est indépendant de celui de la première région (10).

5. Dispositif de protection selon la revendication 2, caractérisé en ce qu'il est obtenu par la suite d'opérations suivantes :
-à partir d'une tranche de matériau semiconducteur, dopé d'un premier type de conductivité et constituant le substrat (7), dépôt sur ses deux faces principales d'une couche d'un matériau diélectrique, et ouverture d'au moins deux fenêtres en vis à vis, de façon à former deux masques (8, 9),
-à travers les fenêtres dans les masques (8, 9), diffusion ou implantation d'une première (10) et d'une seconde (11) régions d'un second type de conductivité, et recuit des impuretés de dopage,
-dépôt de métallisations de prises de contacts (12, 13) sur les surfaces libres des première (10) et seconde (11) régions (8, 9).

# FIG_1

# FIG_2

# FIG_3

n

# FIG_4

n

# FIG_5

n

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENT ABSTRACTS OF JAPAN, vol. 9, no. 302 (E-362)[2025], 29 novembre 1985; & JP-A-60 140 878 (ORIGIN DENKI K.K.) 25-07-1985 * Résumé; figures * | 1-4 | H 01 L 29/90 |
| A | PATENT ABSTRACTS OF JAPAN, vol. 7, no. 4 (E-151)[1149], 8 janvier 1983; & JP-A-57 164 577 (NIPPON DENKI K.K.) 09-10-1982 * Résumé; figures * | 1-3 | |
| A | DE-A-2 838 605 (ROBERT BOSCH GmbH) * Pages 5-7; figures 2-3d * | 1,2,5 | |
| A | FR-A-2 305 028 (I.T.T. INDUSTRIES INC.) * Page 1, ligne 40 - page 2, ligne 17; figures 1,2 * | 1,2,5 | |
| A | PATENT ABSTRACTS OF JAPAN, vol. 6, no. 151 (E-124)[1029], 11 août 1982; & JP-A-57 72 389 (HITACHI SEISAKUSHO K.K.) 06-05-1982 * Résumé; figures * | 1,2 | DOMAINES TECHNIQUES RECHERCHES (Int. Cl.4)<br><br>H 01 L |

Le présent rapport a été établi pour toutes les revendications

| Lieu de la recherche | Date d'achèvement de la recherche | Examinateur |
|---|---|---|
| LA HAYE | 29-02-1988 | BAILLET B.J.R. |